# EUROPÄISCHE PATENTSCHRIFT

(11) **EP 1 241 710 B1**
(45) Veröffentlichungstag und Bekanntmachung des Hinweises auf die Patenterteilung: **09.09.2009**
(21) Anmeldenummer: 02100255.5
(22) Anmeldetag: 14.03.2002
(51) Int. Cl.: H01L 31/0352, H01L 31/103, H01L 27/146

(54) **Lichtsensitives Halbleiterbauelement**
Light-sensitive semiconductor device
Dispositif sémi-conducteur photosensible

(30) Priorität: 15.03.2001 DE 10112374
(43) Veröffentlichungstag der Anmeldung: 18.09.2002
(73) Patentinhaber: Philips Intellectual Property & Standards GmbH, 20099 Hamburg (DE); Koninklijke Philips Electronics N.V., 5621 BA Eindhoven (NL); Fraunhofer-Gesellschaft zur Förderung der angewandten Forschung e.V., 80686 München (DE)
(72) Erfinder: Lauter, Josef c/o Philips Corporate, 52066, Aachen (DE); Kemna, Armin, 47051 Duisburg (DE); Brockherde, Werner, 47259 Duisburg (DE); Hausschild, Ralf, Dr., 42699 Solingen (DE)
(74) Vertreter: Volmer, Georg

(56) Entgegenhaltungen:
- EP-A- 0 908 956
- EP-A- 0 942 472
- EP-A- 0 964 451
- EP-A- 1 026 747
- DE-A1- 19 638 693
- US-A- 5 223 919
- US-A- 6 034 321

## Beschreibung

Die Erfindung betrifft ein lichtsensitives Halbleiterbauelement, enthaltend ein Bahngebiet einer ersten Dotierung und damit in Kontakt stehende Zonen entgegengesetzter Dotierung, wobei im Kontaktbereich des Bahngebietes mit den Zonen ein pn-Übergang entsteht.

Ein Halbleiterbauelement der Eingangs genannten Art ist aus der EP 0 883 187 A1 bekannt. Das Bauelement ist prinzipiell wie eine Halbleiterdiode in CMOS-Technologie aufgebaut. Dabei befindet sich auf einem p-dotierten Substrat ein p- (das heißt schwächer) dotiertes Bahngebiet, in welches eine "punktförmige" bzw. seitlich gering ausgedehnte n-dotierte Zone durch Diffusion oder vorzugsweise Implantation eingesetzt ist. Diese n-dotierte Zone wird im Folgenden aufgrund ihrer Form relativ zum Bahngebiet als "Dot-Zone" bezeichnet. Zwischen der n-dotierten Dot-Zone und dem p-dotierten Bahngebiet bildet sich in bekannter Weise ein pn-Übergang aus.

Die bekannte Halbleiterdiode wird zur Detektion von Lichtquanten in Sperrrichtung gepolt. Ein im lateral weit ausgedehnten Bahngebiet eintreffendes Lichtquant erzeugt dort ein Ladungsträgerpaar, also ein Loch und ein freies Elektron. Die Ladungsträger existieren solange, bis sie durch Rekombination wieder "vernichtet" werden. Bei entsprechend schwacher Dotierung des Bahngebietes stellt sich jedoch eine hohe Lebensdauer ein, während welcher insbesondere der Minoritätsladungsträger (z.B. Elektron im p-Gebiet) eine verhältnismäßig große Strecke durch Diffusionsprozesse zurücklegen kann. Dabei kann der Minoritätsladungsträger insbesondere in die Sperrschicht zwischen dem p-dotierten Bahngebiet und der Dot-Zone gelangen, in welcher er aufgrund des dort herrschenden elektrischen Feldes in die Dot-Zone gezogen wird. Auf diese Weise sammeln sich die von Lichtquanten erzeugten Minoritätsladungsträger des Bahngebietes zu einem großen Teil in der Dot-Zone an, wo sie mit Hilfe entsprechender Auswertungselektronik nachgewiesen werden können.

Anders als bei üblichen lichtsensitiven Halbleiterdioden mit einem planaren pn-Übergang erstreckt sich bei der Diode gemäß der EP 0 883 187 A1 die Dot-Zone nicht großflächig über dem Bahngebiet, sondern sie beschränkt sich vielmehr auf einen minimalen Teil der Fläche des Bahngebietes. Dies hat seinen Grund darin, dass die restliche Fläche über dem Bahngebiet für die Unterbringung integrierter Auswertungselektronik zum Auslesen der Ladung der Halbleiterdiode freigehalten werden soll. Dementsprechend wird diese Fläche über dem p-dotierten Bahngebiet mit einer n++ Dotierung versehen, um eine gegenüber dem Bahngebiet elektrisch isolierte Basis für die genannte Elektronik zu schaffen. Die Größe eines Pixels, das heißt der Fläche eines lichtsensitiven Halbleiterbauelementes, die von der Elektronik selektiv ausgelesen werden kann, ist bei der Diode gemäß der EP 0 883 187 A1 durch die Diffusionslänge der Ladungsträger im p-dotierten Bahngebiet begrenzt. Es können nämlich nur solche Minoritätsladungsträger in einer Dot-Zone nachgewiesen werden, welche diese Dot-Zone über Diffusion erreichen können. Daher können nur verhältnismäßig kleine Pixel realisiert werden. Ferner entsteht aufgrund des ungerichteten Charakters der Diffusion bei einem Bauelement gemäß der EP 0 883 187 A1 ein Übersprechen der Signale zwischen benachbarten Pixeln.

In vielen Anwendungsfällen ist es wünschenswert, lichtsensitive Halbleiterbauelemente mit verhältnismäßig großflächigen Pixeln herzustellen. Ein Beispiel hierfür sind optische Detektoren zum Auslesen von Röntgenszintillatoren. Der Nachweis von Röntgenstrahlung findet in der Regel zweistufig statt, wobei ein Röntgenquant zunächst in einem Szintillatorkristall die Emission von sichtbarem Licht verursacht, welches dann in einem zweiten Schritt von einer lichtsensitiven Halbleiterdiode nachgewiesen wird. Typisch für diesen Prozess ist es, dass sehr geringe Lichtmengen nachgewiesen werden müssen, welche zudem aufgrund der ungerichteten Emission über ein weites räumliches Gebiet verteilt werden. So hat das Pixel eines Halbleiterdetektors für einen Röntgenszintillator typischerweise eine Fläche von 2 mm², wobei der gesamte Detektor in der Regel aus einer Vielzahl solcher Pixel zusammengesetzt ist und in einer typischen Anwendung z.B. eine Ausdehnung von z.B. 4 x 100 cm² aufweist.

Es ist bekannt, dass lichtsensitive Halbleiterbauelemente mit integrierten Verstärkerschaltungen ein Rauschen zeigen, welches mit zunehmender Kapazität der Halbleiterdiode steigt. Die Reduzierung der Kapazität von Detektorelementen ist daher eine zentrale Forderung bei der Realisierung rauscharmer optischer Frontends, die ein lichtempfindliches Element und eine Verstärkerschaltung aufweisen. Dabei ist zu beachten, dass das Bauelement vorteilhafterweise mit üblichen integrativen Halbleitertechniken, beispielsweise CMOS-Techniken hergestellt wird, welche aus technischen Gründen zahlreiche Parameter des Bauelementes festlegen. Dies gilt insbesondere für die Dotierungsstärke des Bahngebietes, so dass diese in der Regel nicht mehr zur Anpassung der Kapazität der Halbleiterdiode zur Verfügung steht.

Aus der EP 0 942 472-A2 ist eine Diode mit reduzierter Kapazität bekannt.

Vor diesem Hintergrund war es Aufgabe der vorliegenden Erfindung, ein lichtsensitives Halbleiterbauelement für einen Röntgendetektor in einem Röntgenuntersuchungsgerät bereitzustellen, welches bei verhältnismäßig großer Pixelfläche eine niedrige Kapazität aufweist und daher insbesondere für den Einsatz bei Röntgenszintillatoren geeignet ist und wobei einzelne Dotierung redundant miteinander verbunden sind. Vorteilhafterweise sollte das Halbleiterbauelement in Standard (CMOS) Prozessschritten hergestellt werden können und eine hohe Strahlenhärte gegenüber ionisierender Röntgenstrahlung, eine gute Kanaltrennung und eine exakt definierte Geometrie aufweisen.

Diese Aufgabe wird durch ein Halbleiterbauelement mit den Merkmalen des Anspruchs 1 gelöst. Vorteilhafte Ausgestaltungen sind in den Unteransprüchen enthalten.

Das Halbleiterbauelement enthält demnach ein Bahngebiet mit einer ersten Dotierung sowie Dot-Zonen, die mit dem Bahngebiet in Kontakt stehen und eine zur Dotierung des Bahngebietes entgegengesetzte Dotierung aufweisen. Demnach können das Bahngebiet p-dotiert und die Dot-Zonen n-dotiert sein oder umgekehrt. Durch diese unterschiedlichen Dotierungen entsteht im Kontaktbereich des Bahngebietes mit einer Dot-Zone jeweils ein pn-Übergang, das heißt eine Halbleiterdiode. Ferner ist bei dem Halbleiterbauelement mindestens eine Gruppe von mehreren Dot-Zonen vorhanden, wobei die Dot-Zonen dieser Gruppe elektrisch parallel miteinander verschaltet sind.

Durch die elektrische Verbindung der Dot-Zonen einer Gruppe lässt sich die in den Dot-Zonen angesammelte Ladung einheitlich auslesen. Das heißt, dass die Dot-Zonen der Gruppe gemeinsam ein Pixel bilden. Die Größe dieses Pixels ist dabei durch die Fläche bestimmt, über welche sich die Gruppe der Dot-Zonen verteilt und kann quasi beliebig groß gemacht werden. Vorzugsweise sind auf dem Halbleiterbauelement viele derartige Gruppen, die jeweils ein Pixel bilden, flächendeckend verteilt angeordnet.

Vorzugsweise sind die Dot-Zonen einer Gruppe zusammenhängend angeordnet. Das heißt, dass jede Dot-Zone der Gruppe mindestens eine benachbarte Dot-Zone hat, die auch Mitglied der Gruppe ist. Typischerweise wird die von den Dot-Zonen bedeckte Fläche rechteckig begrenzt oder in sonstiger Weise kompakt gestaltet sein.

Weiterhin folgt die Verteilung der Dot-Zonen auf dem Bahngebiet vorzugsweise einem hexagonalen Muster. Das bedeutet, dass an jede Dot-Zone im Mittelpunkt eines Sechsecks liegt, dessen Ecken wiederum mit Dot-Zonen besetzt sind Die kleinste geometrische Zelle dieser Anordnung ist ein gleichseitiges Dreieck, an dessen Ecken Dot-Zonen sitzen.

Der Aufbau eines Pixels aus hexagonal angeordneten und elektrisch gekoppelten Dot-Zonen führt zu einem Detektorelement mit einer erheblich verringerten Kapazität bei gleichzeitig guter Empfindlichkeit in der gesamten von der Gruppe belegten Pixelfläche. Anders als bei üblichen Detektordioden erstreckt sich dabei die Sperrschicht, von deren Fläche die Kapazität der Diode annähernd proportional abhängt, nicht über die gesamte Pixelfläche, sondern nur über kleine, "punktförmige" Bereiche. Dennoch werden praktisch alle in der Pixelfläche durch Lichteinfall erzeugten Ladungsträger nachgewiesen, da sie aus Bereichen des Bahngebietes außerhalb der Sperrschicht in die Sperrschicht hinein diffundieren können, wo sie dann zur Dot-Zone abgeleitet werden. Durch die hexagonale Anordnung der Dot-Zonen auf der Pixelfläche lässt sich dabei sicherstellen, dass mit einer möglichst kleinen Gesamtfläche bzw. Anzahl der Dot-Zonen eine optimale Abschöpfung der erzeugten Minoritätsladungsträger erfolgen kann. Das heißt, dass die Kapazität des Pixels klein ist bei gleichzeitig nahezu vollständigem Nachweis von in der Pixelfläche einfallendem Licht.

Die elektrische Verbindung der Dot-Zonen einer Gruppe geschieht so, dass jede Dot-Zone über mindestens zwei Strompfade an eine Sammelleitung angeschlossen ist. Insbesondere kann dies durch mehrere parallel verlaufende elektrische Leitungen geschehen, die in üblicher Weise auf dem Halbleiterbauelement aufgebracht sind und die an den gegenüberliegenden Rändern der von der Gruppe belegten Fläche elektrisch an eine Sammelleitung angeschlossen sind. Der Leitungsverlauf wird dabei vorzugsweise so gewählt, dass mit einer möglichst geringen Menge an Metall alle Dot-Zonen elektrisch an die Sammelleitung angeschlossen werden können, damit die durch die Metallabdeckung für den Lichtnachweis verlorengehende Detektorfläche möglichst gering ist. Der doppelte bzw. mehrfache Anschluss der jeweiligen Leitungen an eine um die Pixelfläche umlaufende Sammelleitung hat den Vorteil einer Redundanz, so dass auch bei einem eventuellen Leitungsbruch an einer Stelle die Ladungen aller an die Leitung angeschlossenen Dot-Zonen noch zur Sammelleitung geführt werden können.

Gemäß einer Weiterbildung der Erfindung werden die Dot-Zonen einer Gruppe (eines Pixels) von einem umlaufenden Guardring umgeben, wobei der Guardring als entgegengesetzte und vorzugsweise tiefergehende Dotierung im Bahngebiet ausgebildet ist. Der Guardring bildet somit einen linienförmigen pn-Übergang im Bahngebiet aus, der die aktive Fläche des Pixels umrandet und dabei die niedrig dotierten Bahngebiete der einzelnen Pixel abschnürt. Dies kann insbesondere durch eine tiefe Dotierung des Guardringes (vorzugsweise durch Diffusion) sowie das Anlegen einer Gegenspannung an den Guardring sichergestellt werden. Der Guardring sorgt somit dafür, dass die verschiedenen Pixel voneinander sauber getrennt sind und nicht in der Fläche eines Pixels erzeugte Minoritätsladungsträger zum anderen Pixel hinüber wandern und dort nachgewiesen werden.

Die Dot-Zonen in Nachbarschaft zu einem Guardring werden vorzugsweise mit höherer Dichte angeordnet. Insbesondere können zusätzliche Dots in konstantem Abstand zum Guardring hinzugefügt werden, um eine gleichmäßige Empfindlichkeit im Randbereich des Pixels zu erzielen. Durch den Guardring und die zusätzlichen Dot-Zonen wird zusätzlich das Frequenzverhalten des Detektors verbessert, da die langsame Eindiffusion von fotogenerierten Ladungsträgern aus benachbarten Gebieten verhindert wird.

Die Oberfläche des Bahngebietes zwischen den Dot-Zonen weist vorzugsweise eine sogenannte Schwellspannungsimplantation auf. Eine solche Schwellspannungsimplantation ist vom gleichen Dotierungstyp (p oder n) wie das Bahngebiet, auf dem sie erzeugt wird, und wird in der Regel bei allen CMOS-Halbleiterdioden vorgesehen, um die sogenannte "schwache Inversion" zu unterdrücken. Bei dem erfindungsgemäßen lichtsensitiven Halbleiterbauelement hat eine Schwellspannungsimplantation den positiven Effekt, dass aufgrund der in Richtung senkrecht zur Oberfläche des Bahngebietes veränderlichen Dotierungsstärken elektrische Felder entstehen, welche eine zur Seite gerichtete Diffusion von Ladungsträgern unterstützen. Dadurch verlängert sich die Lebensdauer von durch Licht erzeugten Minoritätsladungsträgern, was wiederum die Chancen eines Nachweises in einer Dot-Zone erhöht.

Das Bahngebiet ist vorzugsweise so hergestellt, dass dort durch Licht erzeugte Minoritätsladungsträger eine möglichst große Diffusionslänge haben. Diese liegt typischerweise im Bereich von 50 bis 200 µm. Durch große Diffusionslängen wird die Chance erhöht, dass ein Minoritätsladungsträger durch seine Diffusion zufällig das Gebiet einer Sperrschicht bzw. einer Dot-Zone erreicht, wo er dann nachgewiesen wird. Die Beeinflussung der Diffusionslänge kann bei der Herstellung des Bahngebietes z.B. durch eine schwache Dotierung, wenig Implantation, wenige Prozesschritte und dergleichen erfolgen.

Um die Ausbeute an nachgewiesenen Minoritätsladungsträgern aus dem angrenzenden Bahngebiet ausreichend hoch einzustellen, werden die Dot-Zonen vorzugsweise mit einem Abstand voneinander angeordnet, der in der Größenordnung der Diffusionslänge der Minoritätsladungsträger im Bahngebiet liegt. Das heißt, dass dieser Abstand etwa zwischen 10 und 200 % der Diffusionslänge beträgt.

Die Fläche der vorzugsweise kreisförmig oder rechteckig ausgebildeten Dot-Zonen wird vorzugsweise mit der minimalen Strukturgröße hergestellt, die der angewendete Prozess zulässt. Typischerweise beträgt die Fläche zwischen 1 und 5 µm², vorzugsweise ca. 2 µm². Eine derartige Flächengröße erlaubt einerseits noch eine hinreichend gute Kontaktierung der Dot-Zonen durch (metallische) Leitungen, andererseits ist die Fläche hinreichend klein, um die angestrebte Kapazitätsminimierung zu gewährleisten.
Die Dot-Zonen einer Gruppe (Pixel) werden vorzugsweise so angeordnet, dass sie ein etwa rechtwinkliges Gebiet ausfüllen, dessen Fläche ca. 0,5 bis 5 mm², besonders bevorzugt ca. 1 mm² beträgt. Derartige für optische Halbleiterbauelemente große Flächen werden insbesondere bei den Pixeln von Röntgendetektoren benötigt, um das in einem Szintillatorkristall erzeugte Licht möglichst vollständig zu erfassen. Mit Hilfe der vorliegenden Erfindung können dabei trotz der großen Fläche hinreichend kleine Kapazitäten der Halbleiterdiode sichergestellt werden, so dass eine empfindliche und mit geringem Rauschen auszulesende Detektoranordnung entsteht.

Zur Herstellung des oben beschriebenen Halbleiterbauelementes wird vorzugsweise die CMOS-Technik eingesetzt, welche ein Industriestandard ist und zur Integration der Elektronik genutzt werden kann. Durch die hexagonale Anordnung elektrisch verbundener Dot-Zonen ist dabei eine Kapazitätsverringerung des entstehenden Diodendetektors auch dann möglich, wenn dieser Detektor im übrigen mit Standard-CMOS-Parametern hergestellt wird, die insbesondere die Dotierungsstärken von Bahngebieten festlegen.

Die Aufgabe wird auch mit einem Röntgendetektor mit einem lichtsensitiven Halbleiterbauelement nach Anspruch 14 gelöst.

Außerdem wird die Aufgabe auch mit einem Rötgenuntersuchungsgerät mit einem Röntgendetektor und einem lichtsensitiven Halbleiterbauelement nach Anspruch 15 gelöst.

Im Folgenden wird die Erfindung mit Hilfe der Figuren beispielhaft erläutert. Es zeigt:
- Fig. 1: eine Aufsicht auf ein Pixel eines erfindungsgemäßen lichtsensitiven Halbleiterbauelementes;
- Fig. 2: einen Querschnitt durch den Halbleiter nach Figur 1 entlang der Linie II-II, welcher zwei Dot-Zonen erfasst.

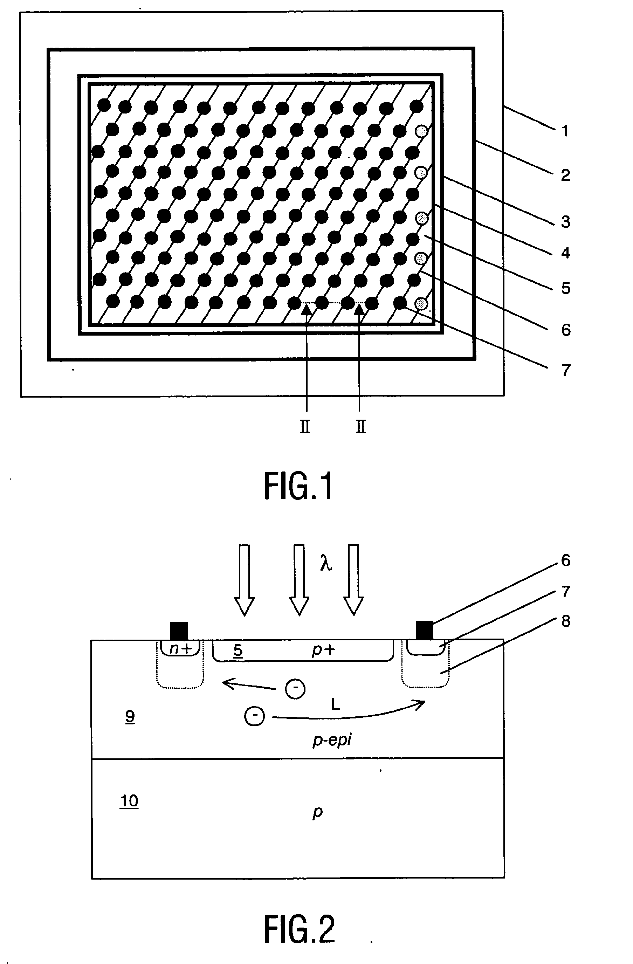

Das in den Figuren dargestellte Beispiel für die erfindungsgemäße Ausgestaltung eines Hableiterbauelementes zeigt eine Möglichkeit auf, großflächige Fotosensorelemente in CMOS-Technologie herzustellen. Figur 1 zeigt dabei ein Pixel 1 eines solchen Halbleiterbauteils, wobei eine Vielzahl derartiger Pixel neben- und untereinander angeordnet sein können, um eine Detektorfläche von typischerweise mehreren Quadratzentimetern zu füllen. Das einzelne Pixel 1 sblbst hat dabei eine Kantenlänge in der Größenordnung von 1 mm, das heißt eine Fläche von ca. 1 mm².

Wie in Figur 1 schematisch dargestellt ist, wird die Pixelfläche von einem p-Kontakt 2 sowie einem Guardring 3 eingerahmt. Bei dem Guardring handelt es sich um einen linienförmigen pn-Übergang, welcher insbesondere durch eine tiefe n-well (das heißt eindiffundierte) Dotierung in dem p-dotierten Bahngebiet 9 (Figur 2) gebildet werden kann. Zusätzlich kann der Guardring 3 im Betrieb an eine Gegenspannung gelegt werden, um die Sperrfunktion aktiv zu unterstützen. Durch den Guardring 3 wird verhindert, dass in der Pixelfläche durch Lichteinfall erzeugte Ladungsträger durch Diffusion das Gebiet des Pixels verlassen und in das Gebiet eines angrenzenden Pixels eindiffundieren können. Der Guardring sorgt somit für eine Unterdrückung von Übersprechen (Blurr) und damit für eine saubere Trennung der Pixel.

Die aktive Pixelfläche, in welcher einfallende Lichtquanten nachgewiesen werden, wird im Wesentlichen durch die Fläche innerhalb des Guardringes gebildet. Die Pixelfläche wird dabei aus einem p-dotierten Bahngebiet 9 gebildet, auf welches (n+)-dotierte Dot-Zonen 7 aufgebracht sind Wie insbesondere aus Figur 1 hervorgeht, sind die Dot-Zonen 7 dabei in einer hexagonalen Anordnung über die Fläche verteilt. Diese hexagonale Anordnung gewährleistet bei einer gegebenen Anzahl der Dot-Zonen 7, welche die Kapazität des Bauelementes (Pixels) bestimmt, die größtmögliche Empfindlichkeit.

Wie aus Figur 1 weiterhin erkennbar ist, sind die Dot-Zonen 7 durch parallel unter 60° zu den Pixelrändern geneigt verlaufende metallische Leitungen 6 miteinander verbunden, wobei die Leitungen 6 im Randbereich der Pixelfläche durch eine umlaufende Sammelleitung 4 elektrisch verbunden werden. Die in den Dot-Zonen 7 angesammelten Ladungsträger können somit über die Sammelleitung 4 abgeschöpft und in einer Auswerteelektronik (nicht dargestellt) ausgewertet werden. Die Auswerteelektronik kann insbesondere in den Bereichen zwischen zwei Pixeln untergebracht werden.
Zur Definition und zur Optimierung der aktiven Fläche des Bauelementes können im Randbereich des Pixels, das heißt in der Nähe des Guardringes 4, die Dot-Zonen mit einer größeren Dichte angeordnet sein So sind in Figur 1 am rechten Rand der Pixelfläche fünf zusätzliche Dot-Zonen erkennbar, deren Platzierung vom ansonsten vorherrschenden hexagonalen Anordnungsmuster abweicht.

In Figur 2 ist ein Querschnitt durch das Halbleiterbauelement nach Figur 1 dargestellt, welcher entlang der Linie II-II senkrecht zur Oberfläche verläuft und zwei benachbarte Dot-Zonen 7 erfasst.

Wie aus dem Querschnitt erkennbar ist, ist der Halbleiter gemäß üblicher CMOS-Technologie auf einem p-dotierten Siliziumsubstrat 10 aufgebaut. Auf dem Substrat 10 befindet sich eine ebenfalls p-dotierte Epitaxieschicht 9, die vorliegend als Bahngebiet bezeichnet wird. Das Bahngebiet 9 ist niedrig dotiert, zum Beispiel mit einer Dotierungsstärke von 10¹⁴/cm³. Von außen auf das Halbleiterbauelement auftreffende Lichtquanten der Wellenlänge λ können bis das Bahngebiet 9 eindringen und erzeugen dort Ladungsträgerpaare. Aufgrund der Herstellungsbedingungen wie z.B. der geringen Dotierung des Bahngebietes 9 weisen dabei die Minoritätsladungsträger (vorliegend Elektronen e ) eine verhältnismäßig große Lebensdauer auf, während der sie durch Diffusion weite Strecken zurücklegen können. Die mittlere zurückgelegte Strecke wird als Diffusionslänge L der Minoritätsladungsträger bezeichnet und liegt typischerweise in der Größenordnung von 100 µm.

Mit einem Abstand, der grob gesehen der Größenordnung der Diffusionslänge L entspricht und zwischen ca. 30 und 550 µm liegt, sind auf der Oberfläche des Bahngebietes 9 Dot-Zonen 7 angeordnet. Die Dot-Zonen 7 werden durch eine n+ Dotierung (vorzugsweise durch Eindiffusion) im Bahngebiet 9 erzeugt, wobei die Dotierungsstärke typischerweise bei 10¹⁶/cm³ liegt. Zwischen der (n+)-dotierten Dot-Zone 7 und dem p-dotierten Bahngebiet 9 bildet sich in bekannter Weise die Sperrschicht oder Verarmungszone 8 einer Halbleiterdiode aus, die durch eine Polung in Spernichtung noch vergrößert wird. Auf den Dot-Zonen 7 befinden sich die metallischen Leitungskontakte 6, welche in der in Figur 1 gezeigten Weise alle Dot-Zonen elektrisch miteinander verbinden.
Wenn die im Bahngebiet 9 durch Lichteinfall erzeugten Minoritätsladungsträger durch Diffusion in die Verarmungszone 8 gelangen, werden sie von dem dort herrschenden elektrischen Feld erfasst und zur Dot-Zone 7 geleitet. Von dort können sie dann über die Kontakte 6 zu einer entsprechenden Auswertungselektronik abgeleitet werden, um als Nachweis für das Licht zu dienen. Obwohl die Dot-Zonen 7 nur eine sehr geringe Fläche von typischerweise 2 µm² einnehmen, sammeln sie durch den Diffusionsprozess Ladungsträger aus einem lateral weit ausgedehnten Bereich des Bahngebietes 9. Das bedeutet, dass die Kapazität des Halbleiterbauelementes, die durch die Gesamtfläche der Dot-Zonen 7 des Pixels 1 bestimmt wird, klein gehalten werden kann und dennoch aus der gesamten Pixelfläche ein Lichtnachweis möglich ist.

Die hexagonale Anordnung der Dot-Zonen 7 gewährleistet, dass die Minoritätsladungsträger nach einer minimalen Diffusionsstrecke eine Dot-Zone 7 beziehungsweise die zugehörige Sperrschicht 8 erreichen, so dass ein guter Kompromiss zwischen Abstand der Dot-Zonen 7 und Empfindlichkeit des Bauteils erzielt wird. Ferner wird durch den Abstand der Dot-Zonen 7 die Bandbreite des Sensors eingestellt. Die Verwendung der hexagonalen Struktur erlaubt in diesem Fall die Steigerung der Bandbreite gegenüber allen anderen denkbaren Anordnungen.

Da die Ladungssammlung und Ladungsbewegung im Bahngebiet 9 diffusiver Natur ist, würde es ohne Gegenmaßnahmen zu einem Übersprechen zwischen benachbarten, dicht gepackten Pixeln kommen. Ein solches Übersprechen würde durch Ladungsträger verursacht, die in einem ersten Bahngebiet generiert werden, aber in das Bahngebiet eines benachbarten Pixels ausdiffundieren. Die Ausdiffusion wird vorliegend jedoch durch den Guardring 3 verhindert.

In Figur 2 ist ferner erkennbar, dass an der Oberfläche des Bahngebietes 9 zwischen den Dot-Zonen 7 eine (p+)-dotierte Schicht 5 vorgesehen ist. Bei dieser Schicht 5 handelt es sich um eine bei der CMOS-Technik standardmäßig hergestellte (flache) Schwellspannungsimplantation zur Unterdrückung der schwachen Inversion zur Isolation der Dot-Zonen 7 am Si-SiO Interface. Durch die unterschiedliche Dotierungsstärke in der Schwellspannungsimplantation 5 und im Bahngebiet 9 entstehen elektrische Felder, die sich vorteilhaft auf die Bewegung der Minoritätsladungsträger auswirken. Das heißt, dass die Ladungsträger durch diese Felder vorzugsweise seitlich zu den Dot-Zonen 7 hin gedrängt werden.

## Patentansprüche

1. Lichtsensitives Halbleiterbauelement, enthaltend
ein Bahngebiet (9) einer ersten Dotierung und
damit in Kontakt stehende Dot-Zonen (7) entgegengesetzter Dotierung,
wobei im Kontaktbereich des Bahngebietes mit jeder Dot-Zone ein pn-Übergang entsteht,
wobei mindestens eine Gruppe von Dot-Zonen, die elektrisch parallel miteinander verschaltet sind, vorhanden ist, **dadurch gekennzeichnet, dass** die Dot-Zonen (7) jeweils über mindestens zwei Strompfade (6) an einer Sammelleitung (4) angeschlossen sind.

2. Halbleiterbauelement nach Anspruch 1,
**dadurch gekennzeichnet,**
**dass** die Dot-Zonen (7) der Gruppe zusammenhängend angeordnet sind.

3. Halbleiterbauelement nach Anspruch 1 oder 2,
**dadurch gekennzeichnet,**
**dass** die Dot-Zonen (7) der Gruppe in einer hexagonalen Verteilung auf dem Bahngebiet angeordnet sind.

4. Halbleiterbauelement nach mindestens einem der Ansprüche 1 bis 3,
**dadurch gekennzeichnet,**
**dass** die Dot-Zonen (7) einer Gruppe von einem umlaufenden Guardring (3) umgeben werden, welcher als entgegengesetzte und vorzugsweise tiefgehende Dotierung im Bahngebiet (9) ausgebildet ist.

5. Halbleiterbauelement nach Anspruch 4,
**dadurch gekennzeichnet,**
**dass** die Dot-Zonen (7) in Nachbarschaft zum Guardring (3) verdichtet angeordnet sind.

6. Halbleiterbauelement nach mindestens einem der Ansprüche 1 bis 5,
**dadurch gekennzeichnet,**
**dass** die Oberfläche des Bahngebietes (9) zwischen den Dot-Zonen (7) eine Schwellspannungsimplantation (5) aufweist.

7. Halbleiterbauelement nach mindestens einem der Ansprüche 1 bis 6,
**dadurch gekennzeichnet,**
**dass** das Bahngebiet (9) p-dotiert und die Dot-Zonen (7) n-dotiert sind oder umgekehrt.

8. Halbleiterbauelement nach mindestens einem der Ansprüche 1 bis 7,
**dadurch gekennzeichnet,**
**dass** das Bahngebiet (9) so hergestellt ist, so dass Minoritätsladungsträger eine Diffusionslänge (L)von 50 bis 200 µm erreichen.

9. Halbleiterbauelement nach mindestens einem der Ansprüche 1 bis 8,
**dadurch gekennzeichnet,**
**dass** der Abstand benachbarter Dot-Zonen (7) 10 bis 200 % der Diffusionslänge (L) der Minoritätsladungsträger im Bahngebiet (9) beträgt.

10. Halbleiterbauelement nach mindestens einem der Ansprüche 1 bis 9,
**dadurch gekennzeichnet,**
**dass** die Fläche der Dot-Zonen (7) eine prozessabhängig minimale Strukturgröße aufweist, die vorzugsweise etwa 1 bis 5 µm² beträgt.

11. Halbleiterbauelement nach mindestens einem der Ansprüche 1 bis 10,
**dadurch gekennzeichnet,**
**dass** die Dot-Zonen (7) einer Gruppe ein etwa rechtwinkliges Gebiet (1) ausfüllen, dessen Fläche etwa 0,5 bis 5 mm², vorzugsweise etwa 1 mm² beträgt.

12. Halbleiterbauelement nach mindestens einem der Ansprüche 1 bis 11,
**dadurch gekennzeichnet,**
**dass** es in CMOS-Technologie hergestellt ist.

13. Röntgendetektor mit
einem lichtsensitiven Halbleiterbauelement nach Anspruch 1.

14. Röntgenuntersuchungsgerät
mit einem Röntgendetektor nach Anspruch 13.

## Claims

1. A photosensitive semiconductor component comprising:
a track region (9) of a first doping type and
dot zones (7) in contact therewith and of an opposed doping type,
wherein a pn junction arises at the contact region of the track region with each of the dot zones such that at least one group of dot zones is present which are connected electrically in parallel to one another,
**characterized in that**
the dot zones (7) are each connected to a collective current line (4) via at least two current paths (6).

2. A semiconductor component as claimed in claim 1,
**characterized in that**
the dot zones (7) of said group are arranged in a correlated manner.

3. A semiconductor component as claimed in claim 1 or 2,
**characterized in that**
the dot zones (7) of said group are arranged in a hexagonal distribution on the track region.

4. A semiconductor component as claimed in claims 1 to 3,
**characterized in that**
the dot zones (7) of a group are surrounded by a wide guard ring (3) which is formed as an opposed-type and preferably deep doping in the track region (9).

5. A semiconductor component as claimed in claim 4,
**characterized in that**
the dot zones (7) are more densely distributed in the vicinity of the guard ring (3).

6. A semiconductor component as claimed in at least one of the claims 1 to 5,
**characterized in that**
the surface of the track region (9) between the dot zones (7) has a threshold voltage implantation (5).

7. A semiconductor component as claimed in at least one of the claims 1 to 6,
**characterized in that**
**that** the track region (9) is p-type doped and the dot zones (7) are n-type doped, or vice versa.

8. A semiconductor component as claimed in at least one of the claims 1 to 7,
**characterized in that**
the track region (9) is manufactured such that minority charge carriers reach a diffusion length (L) of 50 to 200 µm.

9. A semiconductor component as claimed in at least one of the claims 1 to 8,
**characterized in that**
the distance between mutually adjoining dot zones (7) amounts to 10% to 200% of the diffusion length (L) of the minority charge carriers in the track region (9).

10. A semiconductor component as claimed in at least one of the claims 1 to 9,
**characterized in that**
the surface area of each of the dot zones (7) has a structural size that is dependent on the process, which size is preferably approximately 1 to 5 µm².

11. A semiconductor component as claimed in at least one of the claims 1 to 10,
**characterized in that**
the dot zones (7) of a group occupy an approximately rectangular region (1) whose surface area is approximately 0.5 to 5 mm², preferably approximately 1 mm².

12. A semiconductor component as claimed in at least one of the claims 1 to 11,
**characterized in that**
it is manufactured according to the CMOS technology.

13. An X-ray detector comprising a photosensitive semiconductor component as claimed in claim 1.

14. An X-ray diagnostic device comprising an X-ray detector as claimed in claim 13.

## Revendications

1. Dispositif semi-conducteur photosensible, contenant une zone de
parcours (9) d'un premier dopage et d'un dopage opposé aux zones de dopage (7) se trouvant ainsi en contact, une transition pn étant formée dans la zone de contact de la zone de parcours avec chaque zone de dopage, au moins un groupe des zones de dopage qui sont commutées électriquement les unes avec les autres en parallèle, étant présent, **caractérisé en ce que** les zones de dopage (7) sont raccordées par au moins deux chemins de courant (6) à un collecteur (4).

2. Dispositif semi-conducteur selon la revendication 1, **caractérisé en ce que** les zones de dopage (7) du groupe sont disposées de façon contiguës.

3. Dispositif semi-conducteur selon la revendication 1 ou 2, **caractérisé en ce que** les zones de dopage (7) du groupe sont disposées en une répartition hexagonale sur la zone de parcours.

4. Dispositif semi-conducteur selon au moins l'une des revendications 1 à 3, **caractérisé en ce que** les zones de dopage (7) d'un groupe sont entourées d'un anneau garde périphérique (3) qui est formé en tant que dopage opposé et de préférence profond dans la zone de parcours (9).

5. Dispositif semi-conducteur selon la revendication 4, **caractérisé en ce que** les zones de dopage (7) sont disposées de façon compacte à proximité de l'anneau garde (3).

6. Dispositif semi-conducteur selon au moins l'une des revendications 1 à 5, **caractérisé en ce que** la surface de la zone de parcours (9) entre les zones de dopage (7) présente une implantation de tension de seuil (5).

7. Dispositif semi-conducteur selon au moins l'une des revendications 1 à 6, **caractérisé en ce que** la zone de parcours (9) a un dopage P et les zones de dopage (7) ont un dopage N ou inversement.

8. Dispositif semi-conducteur selon au moins l'une des revendications 1 à 7, **caractérisé en ce que** la zone de parcours (9) est produite de telle sorte que les porteurs minoritaires atteignent une longueur de diffusion (L) de 50 à 200 µm.

9. Dispositif semi-conducteur selon au moins l'une des revendications 1 à 8, **caractérisé en ce que** la distance de zones de dopages voisines (7) est de 10 à 200 % de la longueur de diffusion (L) des porteurs minoritaires dans la zone de parcours (9).

10. Dispositif semi-conducteur selon au moins l'une des revendications 1 à 9, **caractérisé en ce que** la surface des zones de dopage (7) présente une dimension de structure minimale dépendante du processus qui est de préférence d'environ 1 à 5 µm².

11. Dispositif semi-conducteur selon au moins l'une des revendications 1 à 10, **caractérisé en ce que** les zones de dopage (7) d'un groupe remplissent une zone (1) à peu près à angle droit dont la surface est d'environ 0,5 à 5 mm², de préférence d'environ 1 mm².

12. Dispositif semi-conducteur selon au moins l'une des revendications 1 à 11, **caractérisé en ce qu'**il est produit en technologie CMOS.

13. Détecteur radiographique comportant un dispositif semi-conducteur photosensible selon la revendication 1.

14. Dispositif d'examen radiographique comportant un détecteur radiographique selon la revendication 13.
